Europäisches Patentamt

European Patent Office

Office européen des brevets

(11) Publication number: **0 319 082**

**A1**

## (12) EUROPEAN PATENT APPLICATION

(21) Application number: **88202657.8**

(22) Date of filing: **24.11.88**

(51) Int. Cl.4: **H01L 21/20**

(30) Priority: **25.11.87 US 125271**

(43) Date of publication of application:
**07.06.89 Bulletin 89/23**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Ramesh, Subramanian**
**c/o INT. OCTROOIBUREAU B.V. Prof.**
**Holstlaan 6**
**NL-5656 AA Eindhoven(NL)**

(74) Representative: **Rensen, Jan Geert et al**
**Internationaal Octrooibureau B.V. Prof.**
**Holstlaan 6**
**NL-5656 AA Eindhoven(NL)**

(54) **Method of forming a thin monocrystalline layer of a semiconductor material on a substrate.**

(57) A methof of forming a thin monocrystalline layer of a semiconductor material on an insulator, said method comprising depositing a thin polycrystalline or amorphous layer of a semiconductor material on an insulating substrate to form a layered structure and focusing beams from two lamps on the layer of semiconductor material. According to the invention the center of said beams coincide to form a line image on said layer, the power distribution of said layer being such as to provide a narrow melt zone in said layer of semiconductor material at the center of the line image surrounded by two narrow heated zones, the temperature of said narrow heated zones being below the temperature of said melt zone and said narrow heated zone having a temperature differential of from 2-10 °C/mm decreases from said melt zone while scanning said layered structure relative to said line image and heating said substrate to a temperature below the temperature of said heated zone. Thus the formation sub-grain boundaries is prevented.

FIG.2

FIG.3

## Method of forming a thin monocrystalline layer of a semiconductor material on a substrate.

The invention of this application is concerned with a method of producing monocrystalline layers of semiconductor materials on insulating layers. In particular the invention is concerned with the formation of thin monocrystalline layers of silicon on insulators, the so called SOI structure.

In the production of thin layers of monocrystalline silicon on insulating layers of a thin layer of polycrystalline or amorphous silicon is deposited on an insulating substrate particularly monocrystalline silicon, oxidized silicon or quartz. By localized heating of the silicon layer a small molten zone is produced in the silicon layer which molten zone is scanned across the silicon layer while the underlying substrate is heated. As the molten layer of silicon recrystallizes the silicon layer is converted to a monocrystalline layer.

Such a procedure is well-known in the art, examples in being shown in European Application EPA-0129261, Anthony, United States Patent 4,585,493, Klein, United States Patent 4,590,130, J. Sakurai, J. Electrochem Soc. Solid-State Science and Technology, pp. 1485-1488 (July, 1986), C.L. Bleil et al, Mat. Res. Soc. Symp. Proc. Vol. 35, pp. 389-692 and Japanese Kokai 61-19116.

The problem with these prior arts is that while the zone melting methods disclosed produce monocrystalline layers the monocrystalline layers contain an undesirable concentration of defects. These defects are found primarily to be the presence of sub-grain or low angle grain boundaries. These sub-grain boundaries are believed to arise due to stresses in the growing crystal. These stresses are believed to be chemical impurities, surface, surface roughness, volume expansion or freezing of thermal gradients.

The Japanese Kokai, C.L.Bleil et al and J. Sakurai show examples of the use of low melting glasses such as phosphosilicate glass, borophosphosilicate glass or corning 7059 as substrates underlying the recrystallizable silicon layer. It is taught in these references that by the use of these substrates an alternate mechanism for stress relief is provided so that the formation of low angle grain boundaries will be eliminated or significantly reduced. However, while the use of these substrates results in the reduction of some formation of low angle grain boundaries the formation of these low angle grain boundaries has not been eliminated or even significantly reduced.

The method significantly reducing the formation of low angle grain boundaries is disclosed in copending United States Application 084,657 filed August 11, 1987 and commonly assigned. According to the method disclosed in this copending application, the formation of low angle grain boundaries may be significantly reduced so that thin defect free monocrystalline layers of semiconductor materials of significantly large areas and insulators may be produced. According to the invention, as described in this application, the method involves depositing a thin monocrystalline or amorphous layer of a semiconductor material on a low softening point temperature insulating substrate having a softening point of at least $10\,^{\circ}$C below the melting point of a semiconductor material and the slope of its viscosity versus temperature curve being less than zero and greater than negative infinity, heating the layer of the semiconductor material by means of a zone heating source in such a manner as to provide a convex solid-liquid interface on the layer of the semiconductor material while the layered structure is scanned relative to the zone heating source, the substrate is heated to its annealing point and the scanning speed of the structure relative to the zone heating source is controlled in order to cause the convex solid liquid interface to move along the layer of semiconductor material while the surface of the substrate imposing the layer of the semiconductor material is liquified over the solid-liquid interface.

While this method clearly increases the distance between the defects resulting in the recrystallization to the presence of sub-grain boundaries this method does not prevent the formation of the sub-grain boundaries. By use of this method a 500 $\mu$m wide layer of defect free monocrystalline zone was produced with a length of 2mm. However, for many purposes it is highly desirable that the area of defect free monocrystalline silicon be significantly increased.

An onject of this invention is to provide a method for the formation of thin defect free monocrystalline layers of semiconductor materials on insulating substrates.

According to the invention the method of forming thin monocrystalline layer of a semiconductor material on an insulator comprising the steps of depositing a thin polycrystalline or amorphous layer of a semiconductor material on an insulating substrate to form a layered structure and focusing beams from two lamps on the layer of semiconductor material is characterized in that the center of the beams coincide to form a line image on the layer of semiconductor material the power distribution of these lamps being such as to provide a narrow melt zone in said layer of semiconductor material at the center of the coincided line image surrounded by two narrow heated zones the temperature of the heated zones being below the temperature of the melt zone and the heated zones having a temperature diffenrential of from 2-10°C/mm decreasing from the melt zone in said layered structure direction perpendicular to said line image and heating said substrate to a temperature below the temperature of said heated zone.

It has been found that by the use of the narrow heated zone surrounding the melt zone the presence of a sharp temperature differential is avoided and as a result thereof the formation of defects such as sub-grain boundaries is prevented. The area free of sub-grain boundaries is determined only by the length of the line image formed on the layer of semiconductor material.

While the method of the invention is for forming defect free monocrystalline layers of semiconductor materials generally including silicon and germanium it is particularly adapted for forming thin defect free monocrystalline layers of silicon on an insulating substrate.

The invention further will be expalined referring to the drawing in which :

Fig. 1 is a cross-sectional view of a layered structure used in carrying out the method of the invention;

Fig. 2 illustrated diagrammatically, partially in section and not to scale, of an apparatus for carrying out a method embodying the invention;

Fig. 3 is a graph showing the relative temperature distribution of the temperature in the melt zone temperature of the heated narrow zone surrounding the melt zone in the semiconductor layer and the temperature of the heated substrate;

Fig. 4 is a photograph enlarged about 350 times of a monocrystalline silicon layer formed by the method of the invention and Schimmel etched to highlight the present of sub-grain boundaries, if any.

Various materials well-known in the art may be employed as a substrate. Examples of such materials being quartz, glass, including phosphosilicate glass, monocrystalline silicon and sapphire.

In general, the thickness of the substrate is about 0.2-2mm. However, the thickness of the substrate may vary considerably from this range. Generally the thickness of the polycrystalline or amorphous semiconductor layer is about 0.5-4 $\mu$m however, here too a considerable deviation from these values.

While the layered structire subject to the method of the invention may consist simply of a layer of the semiconductor material on an insulating substrate. Particularly, in those cases where the semiconductor layer is a layer of polycrystalline or amorphous silicon, in order to prevent contamination of the silicon layer the silicon layer may be sandwiched between two layers of silicon dioxide. For further prevention of contamination from the atmosphere this layered structure may be topped with a protective layer such as a thin layer of silicon nitride.

When the substrate is glass it is heated to its annealing point. When the substrate is oxidized silicon it is generally heated to a temperature of about 1000°C-1250°C. Both of these temperatures being below the temperature of the narrow heated zone surrounding the melt zone in the silicon layer.

When the layer to be recrystallized is silicon, the width of the narrow melt zone is 200-800 $\mu$m and the width of the narrow heated zones in the silicon layer is 0.8 to 3mm. The length of the line image depends upon the apparatus employed. The apparatus employed in carrying out the method of the invention produced a line image of 100 mm thereby producing a sub-grain boundaries free monocrystalline layer of silicon of about 100mm wide. While two lamps of proper power distribution may be chosen, it has been found for best results an arc lamp should be employed together with a filament lamp, the narrow beam from the arc lamp serving to provide the melt zone and the wider beam from the filament lamp serving to provide the narrow heated zones. The combination of a mercury arc lamp and a tungsten halogen lamp has been found to be particularly useful for carrying out the method of the invention.

A preferred embodiment of the invention will mow be described with reference to the figures of the drawing and the following example:

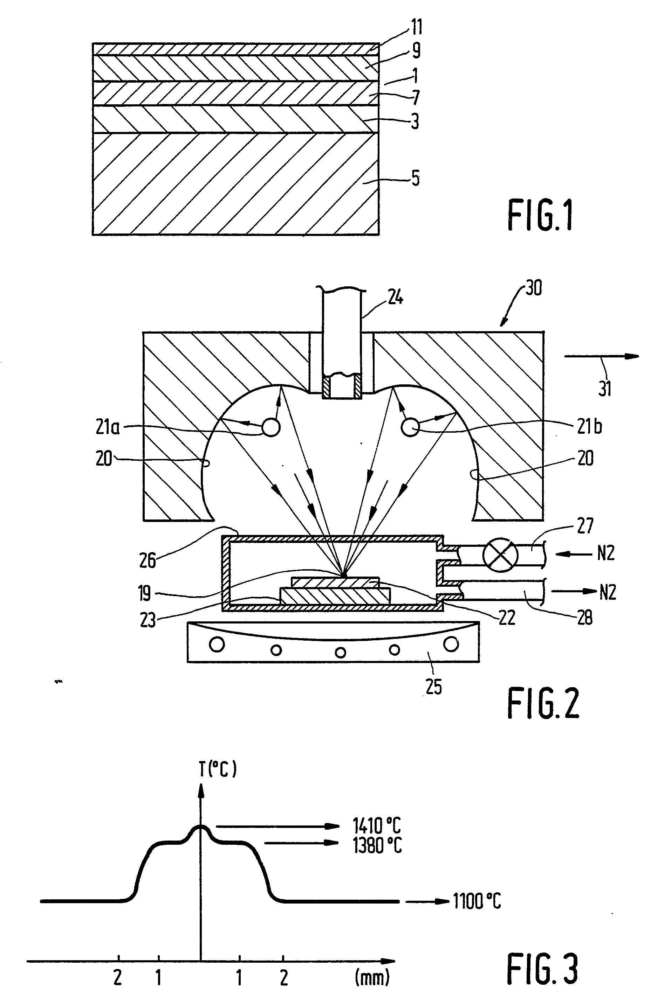

The layered structure 1 shown in Fig. 1 was produced in the following manner by low temperature chemical deposition technique a thin layer of silicon dioxide 3 of a thickness of 2 $\mu$m was deposited on a 0.3 mm thick substrate of monocrystalline silicon 3, a thin layer of polycrystalline silicon 7 of a thickness of about 1.5 $\mu$m was deposited on the layer 3 of silicon dioxide, an additionla layer of silicon dioxide 9 of a thickness of 2 $\mu$m was deposited on the layer of polycrystalline silicon 7 on the layer 1 of silicon dioxide 9 a capping layer 11 of silicon nitride of a thickness of about 600 angstroms was deposited.

An apparatus suitable for carrying out the method of the invention is illustrated in Fig. 2 and comprises an image head 30 having a pair of elliptical reflectors 20 with a 6 kilowatt mercury arc lamp 21a at the focus at one of said reflectors 20 and 1.5 kilowatt tungsten halogen lamp 21b placed at the focus of the reflector 20. The reflectors 20 are each part cylindrical with the axis of each perpendicular to the plane of the drawing having, as shown, in cross-section the shape of part of an ellipse and the lamps are tubular so that a coincident line image 19 is formed on the plane of the polycrystalline silicon layer 22 present in a four inch diameter sample 23 of the layered structure 1. Sample 23 which is to be processed is located within a quartz chamber 26. A viewing system 24 suitable for reflectivity or emissivity measurements is placed in the gaps between the two reflectors 20. A set of bias lamps 25, for example tungsten halogen, located under the quartz chamber 26 provides a means of heating the substrate of the sample 23. An inlet 27 for a supply of nitrogen and an outlet 28 is provided in the quartz chamber 26. The quartz chamber 26 is transparent to infrared and near UV-radiation from the lamps 21a and 21b.

With the sample in place and the lamps in operation a line image of about 100 mm long was produced. The line image was scanned for example at a scan rate of 0.1 mm/sec which was achieved by moving the image head 30 in the direction indicated by arrow 31. While the line image was being scanned in this manner, the silicon substrate was heated to a temperature of about 1100°C by the bias lamp.

A melt zone of less than 500 μm wide with a temperature 1410°C was formed in the layer of polycrystalline silicon along the center of the line image. This melt zone was surrounded by two heated zone regions each about 2 mm wide with a maximum temperature of about 1390°C and temperature differential of from 2-10°C per mm decreasing from the melt zone.

In the sample so processed, a defect free monocrystalline silicon layer of a width of about 100 mm and a length of about 4 inches was formed.

Fig. 3 is a graph showing the temperature of the melt at 1410°C the maximum temperature of the heated areas surrounding the melt of 1390°C and the temperature of the heated substrate at 1100°C, as formed in this example along with the width in millimeters of each of these zones.

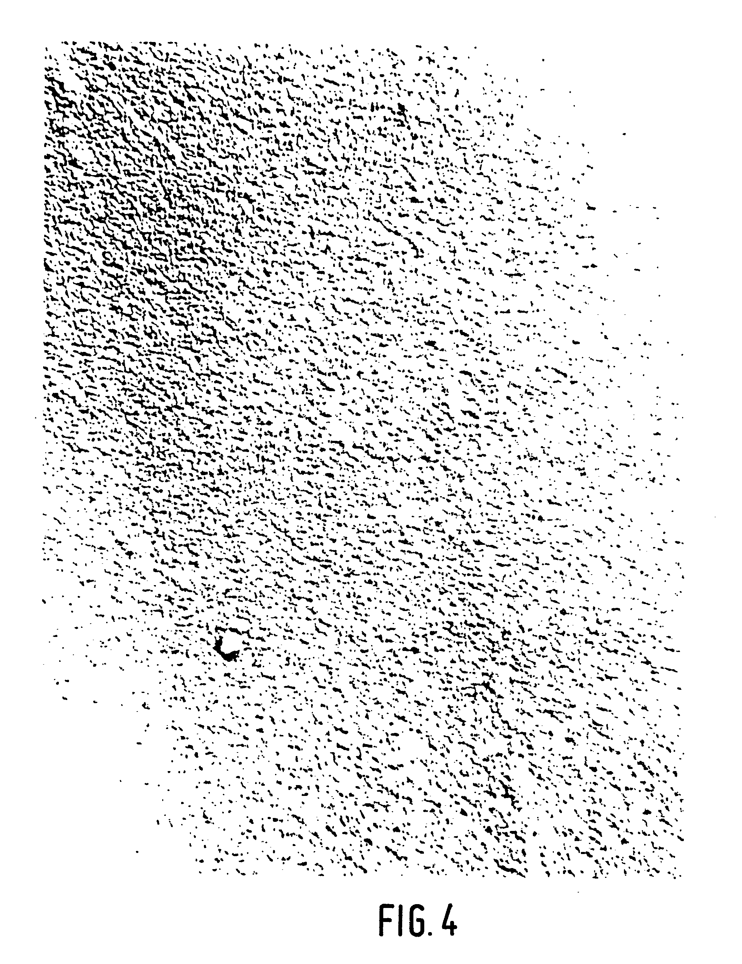

Fig. 4 is a photograph enlarged about 350 times of a 680 um times 500 μm section of the resistant monocrystalline silicon layer. It should be noted from the photograph the resultant monocrystalline film layer is essentially defect free.

In a similar manner a defect free monocrystalline silicon layer of similar dimensions was provided on the layered structure formed of a glass substrate or (a silicon substrate with a 3 μm thick layer of phosphosilicate deposited on it), a 1μm thick silicon dioxide layer deposited on the phosphosilicate glass layer, about a 2um thick layer of polysilicon deposited on the 1um layer of silicon dioxide about a 2um thick layer of silicon dioxide deposited on the layer of polysilicon and a capping layer of silicon nitride of about 600 angstroms thick deposited on the 2μm layer of silicon dioxide.

## Claims

1. A method of forming a thin monocrystalline layer of a semiconductor material on an insulator, said method comprising depositing a thin polycrystalline or amorphous layer of a semiconductor material on an insulating substrate to form a layered structure and focusing beams from two lamps on the layer of semiconductor material characterized in that the center of said beams coincide to form a line image on said layer, the power distribution of said layer being such as to provide a narrow melt zone in said layer of semiconductor material at the center of the line image surrounded by two narrow heated zones, the temperature of said narrow heated zones being nelow the temperature of said melt zone and said narrow heated zone having a temperature differential of from 2-10°C/mm decreases from said melt zone while scanning said layered structure relative to said line image and heating said substrate to a temperature below the temperature of said heated zone.

2. The method of Claim 1 characterized in that the semiconductor material is silicon.

3. The method of Claim 2 characterized in that the substrate is glass.

4. The method of Claim 3 characterized in that the substrate is heated to its annealing point.

5. The method of Claim 2 characterized in that the substrate is monocrystalline silicon.

6. The method of Claim 5 characterized in that the substrate is heated to a temperature of 1000°C-1250°C.

7. The method of Claim 6 characterized in that the substrate is heated to about 1100°C.

8. The method of Claim 2 characterized in that the melt zone is less than about 200-800um in width and the width of each of the narrow heated zones is about 2mm wide.

The method of Claim 7 characterized in that the width of the melt zone is from about 400-500μm.

FIG.1

FIG.2

FIG.3

1-II-PHA 21415

FIG. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | EP-A-0 124 261 (FUJITSU LTD) * Page 3, line 36 - page 4, line 30; claims * | 1,2,5 | H 01 L 21/20 |
| Y | EP-A-0 257 917 (AMERICAN TELEPHONE AND TELEGRAPH CO.) * Abstract; column 6, lines 5-37; claims * | 1,2,5 | |
| A | JAPANESE JOURNAL OF APPLIED PHYSICS SUPPLEMENTS OF THE 15th CONFERENCE ON SOLID STATE DEVICES AND MATERIALS, 1983, pages 35-38, Tokyo, JP; Y. KOBAYASHI et al.: "Recrystallization of polycrystalline silicon islands on fused silica" * Page 35, column 2, lines 9-25; page 36, figure 1 * | 3 | |
| A | APPLIED PHYSICS LETTERS, vol. 51, no. 16, 19th October 1987, pages 1256-1258, American Institute of Physics, New York, US; L. PFEIFFER et al.: "Subboundary-free zone-melt recrystallization of thin-film silicon" * Page 1256, column 1, lines 17-34; figure 1 * | 1,2,5,6 ,8 | TECHNICAL FIELDS SEARCHED (Int. Cl.4) H 01 L |
| A | PATENT ABSTRACTS OF JAPAN, vol. 9, no. 165 (E-327)[1888], 10th July 1985; & JP-A-60 39 818 (TOSHIBA K.K.) 01-03-1985 | | |
| A | PATENT ABSTRACTS OF JAPAN, vol. 9, no. 56 (E-302)[1779], 12th March 1985; & JP-A-59 195 819 (MITSUBISHI DENKI K.K.) 07-11-1984 | | |

The present search report has been drawn up for all claims

| Place of search | Date of completion of the search | Examiner |
|---|---|---|
| THE HAGUE | 16-03-1989 | GELEBART Y.C.M. |

EPO FORM 1503 03.82 (P0401)